(19)

Europäisches
Patentamt
European
Patent Office
Office européen
des brevets

(11) **EP 4 545 980 A1**

(12) **EUROPEAN PATENT APPLICATION**

(43) Date of publication:
**30.04.2025 Bulletin 2025/18**

(21) Application number: **23206018.6**

(22) Date of filing: **26.10.2023**

(51) International Patent Classification (IPC):
*G01R 19/00* (2006.01)     *G01R 31/42* (2006.01)
*H02M 1/00* (2006.01)     *H02M 3/335* (2006.01)
*H03K 17/14* (2006.01)

(52) Cooperative Patent Classification (CPC):
**G01R 19/0092; G01R 31/42; H02M 1/0054;
H02M 1/088; H03K 17/0822;** H02M 1/0009;
H02M 7/5387; H03K 2217/0027

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Airbus S.A.S.**
**31700 Blagnac (FR)**

(72) Inventors:
• **KAPAUN, Florian**
  **82024 Taufkirchen (DE)**

• **STEINER, Gerhard**
  **82024 Taufkirchen (DE)**
• **GALEK, Marek**
  **80335 München (DE)**
• **KLUGBAUER, Josef**
  **80335 München (DE)**
• **GALLA, Gowtham**
  **82024 Taufkirchen (DE)**
• **SURAPANENI, Ravi Kiran**
  **82024 Taufkirchen (DE)**

(74) Representative: **OTN Airbus SAS**
**Airbus Defence and Space GmbH
Willy-Messerschmitt-Straße 1
82024 Taufkirchen (DE)**

(54) **VOLTAGE MEASURING METHOD AND POWER CIRCUIT**

(57)     The invention relates to the field of power electronics. In order to enable a more uniform current flow through multiple power modules that are coupled in parallel during switching operations, a voltage measuring method for measuring voltage in an electrical power circuit (14) comprising at least one switching element is provided. The voltage measuring method comprises measuring the voltage over a parasitic element (42, L1-L4) of the power circuit (14).

Fig. 2

**EP 4 545 980 A1**

## Description

The invention relates to a voltage measuring method for measuring voltage in an electrical power circuit. Further, the invention relates to a power circuit configured to perform such voltage measuring method. Further, the invention relates to an aircraft comprising such a power circuit.

The invention relates to the field of power electronics. Power semiconductor devices, such as power transistor devices, may be coupled in parallel between a high voltage terminal and a low voltage terminal of a power supply in order to increase the power handling capacity. US Patent No. 4,234,805 describes an example of a circuit and method of paralleling power transistor connected as a device for use with electric motor controls. However, even transistors of the same type do not always have identical characteristics. This can lead to the parallel connected transistors not accepting equal portions of the load which can lead to increased losses and unequally distributed losses.

An object of the invention is to provide a method for voltage measuring in a power circuit without influencing the power circuit itself. A further object of the invention is to provide a method for voltage measuring in a power circuit comprising multiple power modules that are coupled in parallel in order to enable a more uniform current flow through these multiple power modules during switching operations.

For achieving such objects, the invention provides a voltage measuring method according to claim 1. A power circuit configured for automatically conducting such method is given in the further independent claim.

Advantageous embodiments are subject-matter of the dependent claims.

The invention provides a voltage measuring method for measuring voltage in an electrical power circuit that comprises at least one switching element. The voltage measuring method comprises measuring the voltage over a parasitic element of the power circuit.

Preferably, the parasitic element is a stray inductance.

As the voltage is measured at a parasitic element of the power circuit, the power circuit itself, e.g. the commutation loop, and also the switching element(s) of the power circuit are not influenced by the measurement method.

Preferably, a time-dependent voltage is measured during a switching operation of the at least one switching element.

Measuring the time-dependent voltage, enables the switching operation to be measured and actively controlled.

Preferably, the voltage is measured over different parasitic elements, e.g. different stray inductances of the power circuit or electrical power modules included in the power circuit.

Preferably, the power module has a half bridge configuration with a high side transistor device and a low side transistor device and the method comprises multiple measurements at different points to distinguish between current in high side and low side transistors in the half bridge configuration.

In an embodiment, the electrical power circuit comprises a plurality of electrical power modules that are coupled in parallel between a high voltage supply terminal and a low voltage supply terminal, e.g. of a power supply. Each electrical power module comprises at least one switching element. The plurality of electrical power modules may be of the same type, e.g. have the same nominal characteristics. In order to account for the fact that in practice, even power modules of the same type are not identical, the voltage measuring method may be carried out for each power module of the plurality of power modules. The switching of one or more of the power modules is adjusted to compensate for any timing differences and provide more uniform current sharing between the power modules. More uniform current sharing between parallel connected power modules can assist in reducing switching losses.

Preferably, the voltage measuring method further measures the voltage u1 over a parasitic element of a first one of the plurality of electrical power modules and measuring the voltage u2 over a parasitic element of a second one of the plurality of electrical power modules, and if u1 and u2 are unequal, adjusting the switching of one or both of the first and second electrical power modules. Thus, the switching of one or both of the first and second electrical power modules may be actively controlled to compensate for any differences in the measured voltage drops and provide more uniform current sharing between the power modules, thus reducing switching losses. This method may be repeated and the difference in current flows reduced stepwise until the measured voltages are equal or until the measured voltages u1 and u2 are reduced to a sufficiently small difference.

In an embodiment, if the difference between $u_1$ and $u_2$ is greater than a predetermined value, the switching of one or both of the first and second electrical power modules is adjusted. This embodiment may be used to allow for the fact that whilst the voltage across the parasitic elements of two or more of the modules is not identical, the difference does not lead to an increase in overall switching losses.

In an alternative embodiment in which the electrical power circuit comprises a plurality of electrical power modules that are coupled in parallel between a high voltage supply terminal or bus and a low voltage supply terminal or bus and each electrical power module comprises at least one switching element, the voltage measuring method further comprises during switching of the first and second modules, a measurement of the time dependent voltage $u_1(t)$ over a parasitic element of a first one of the first and second electrical power modules and the time dependent voltage $u_2(t)$ at the parasitic element of a second one of the first and second electrical power module, and if $u_1(t)$ and $u_2(t)$ are unequal, an adjustment of the switching timing of one or both of the first and second electrical power modules. This method may be repeated until the measured voltages are equal or until the measured voltages $u_1(t)$ and $u_2(t)$ are reduced to a sufficiently small difference.

In an embodiment, if the difference between $u_1(t)$ and $u_2(t)$ is greater than a predetermined value, the switching of one or both of the first and second electrical power modules is adjusted. This embodiment may be used to allow for the fact that the voltage across the parasitic element of two or more of the modules is not identical, but the difference does not lead to an increase in switching losses.

In an embodiment, the method further comprises actively control of the switch-on time and/or switch-off time of one or both of the first and second electrical power modules to symmetrize current flow through the first and second electrical power module during switch-on and switch-off. Symmetrize describes reducing the difference between and/or equalising the current flows in the two or more power modules coupled in parallel. The method may be repeated and the difference in current flows stepwise reduced to an equal value or to an acceptably small difference.

In an embodiment, the method further comprises actively controlling the slope of the switch-on of one or both of the first and second electrical power modules in order to symmetrize current flow through the first and second electrical power module.

In an embodiment, the adjusting the switching of one or both of the first and second electrical power modules comprises controlling the switch-on and/or the switch-off of one or both of the first and second electrical power modules such that the switch-on and/or the switch-off of the first and second electrical modules are non-simultaneous. In other words, the switch-on and/or the switch-off of the first and second electrical modules is controlled so that one module switches on and/or off earlier or later than the other module.

For example, one module may switch on earlier and switch off earlier than the other module. The on-time for both modules may be the same. In another example, one module may switch on earlier and switch off at the same time as the other module and have a larger on-time than the other module.

In an embodiment, the adjustment of the switching of one or both of the first and second electrical power modules comprises shifting the switch-on of one of the first and second electrical power modules compared to the other one of the first and second electrical power modules by a predetermined period t. For example, the switch-on of one of the first and second power modules may be delayed by the predetermined period t so that that module switches on later (by the time period t) than the other module or the switch-on of one of the first and second modules may be moved forward so that that module switches on earlier (by the time period t) than the other module. The predetermined period t may be 10 ns for example.

The method may be repeated and the predetermined time period increased stepwise, e.g. may be increased to 2t, 3t etc, until the measured voltages $u_1$ and $u_2$ of the parasitic element of the first and second electrical power modules, respectively, are symmetrized or balanced, e.g. equalized.

In some embodiments, each electrical power module comprises a half-bridge circuit comprising a high side switch and a low side switch coupled in series at an output node, and if $u_1$ and $u_2$ are unequal, or $u_1(t)$ and $u_2(t)$ are unequal, timing of the switching of the half-bridge circuit of one or both of the first and second electrical power modules is adjusted such that the half-bridge circuits switch non-simultaneously. For example, the switch-on and/or the switch-off of the first and second electrical modules is controlled so that that one module, i.e. the output of the half-bridge circuit, switches on and/or off earlier or later than that of the other module in order to generate synchronous on and off switching of the output. For example, one module may switch on earlier that the other module and switch off earlier than the other module. The on period may be the same.

In some embodiments, the high side switch and the low side switch each comprise a transistor device comprising a gate and the timing of the switching of the half-bridge circuit comprises adjusting the gate control signal supplied to the gate of one or both of the high side switch and the low side switch.

In an embodiment, adjusting the gate control signal supplied to the gate comprises adjusting a pulse pattern of a gate control signal supplied to the gate of one or both of the high side switch and the low side switch.

The transistor device providing the high side switch and the low side switch may be a silicon-based FET, e.g a Metal Oxide Semiconductor Field Effect Transistor (MOSFET), Insulated Gate Bipolar Transistor (IGBT) or a Bipolar Junction Transistor (BJT). A SiC-based or GaN-based device may also be used.

The electrodes or terminals of the transistor device are referred to herein as source, drain and gate. As used herein, these terms also encompass the functionally equivalent terminals of other types of transistor devices. For example, as used herein, the term "source" encompasses not only a source of a MOSFET device but also an emitter of an IGBT device and an emitter of a BJT device, the term "drain" encompasses not only a drain of a MOSFET device but also a collector of an IGBT device and a collector of a BJT device, and the term "gate" encompasses not only a gate of a MOSFET device but also a gate of an IGBT device and a base of a BJT device.

In some embodiments in which the power module has a half bridge configuration, the method comprises multiple measurements of the voltage across different parasitic elements, e.g. different stray inductances that are at different positions in the half-bridge configuration.

This may be used to distinguish between the current flow in high side and low side transistors in the half bridge configuration and the source of asymmetry and switching losses within the module. The switching of one or both of the high and low side transistors of that half-bridge configuration is then actively controlled, e.g. by altering the timing of the switching.

A power circuit configured to perform the voltage measuring method according to any of the preceding embodiments is also provided.

In an embodiment, the power circuit comprises a voltage measurement device configured to measure voltage $u_1$ and $u_2$ of a parasitic element of the first and second electrical power modules, respectively, a computing device configured to determine a difference between $u_1$ and $u_2$ and a control device configured to supply a signal to one or both of the first and second power electrical modules so as to symmetrize current flow through the first and second electrical power module, for example during switch-on and switch-off of the first and second electrical power modules.

In an embodiment, the first and second power modules each comprise a half-bridge circuit comprising a high side switch and a low side switch coupled in series at an output node, and the control circuit comprises a microcontroller or a Field Programmable Gate Array.

The high side switch and the low side switch may be a silicon-based a MOSFET, IBGT or BJT. A SiC-based device may also be used.

In some embodiments, the power circuit is a complete sub-system of a larger power supplying system. The power circuit may be provided in the form of a module. In some embodiments, the power circuit comprises several semiconductor power modules or semiconductor power units, especially semiconductor dies, which are electrically coupled to form the power circuit.

Preferably, the power circuit has a voltage measurement device configured to measure voltage between connection points of the half-bridge configuration.

Preferably, the power circuit has a computing device configured to determine the voltage between the connection points from a known parasitic resistance or inductance parameter between the connection points and the measured voltage.

The voltage measuring method and the power circuit according to preferred embodiments of the invention can be used in different electronic environments. For example, the power circuit is a power module for supplying a personal computer or any other computer or an electric motor. In another example, the power circuit and the current measuring method are used on board of an aircraft.

An aircraft comprising a power circuit according to any of the embodiments described herein is also provided.

The invention relates to the field of power electronics. An improved method for paralleling any kind of power semiconductor devices to equal the losses produced in the semiconductor devices is provided. Power semiconductor devices, such as transistor devices may be coupled in parallel between a high voltage supply bus and a low voltage supply bus in order to increase the current that can be switched.

Actual parallelization of semiconductors works with some semiconductor types that show a PTC (positive temperature coefficient) which means these devices increase their on-state resistance when they become hot and the semiconductor current is reduced. Multiple dies formed of a semiconductor with a PTC (positive temperature coefficient) connected in parallel show some self-balancing behaviour. Unfortunately, this approach is unsuitable for other types of semiconductors as some devices e.g. IGBTs show an NTC (negative temperature coefficient) behavior. Also, in some semiconductors like e.g. SiC, the behaviour changes from PTC to NTC when going down to very low temperatures. The effect of the PTC also takes only the symmetration and losses during on-state into consideration. Despite this degree of self symmetration, unequal switching losses can occur. If signal paths to the single gates of the semiconductors differ in length due to design requirements, this leads to faster/earlier switching of the semiconductors that are mounted closer to the driver so that in some situations current is taken only by these dies which leads to losses.

Preferred embodiments of the invention provide a method that allows to actively symmetrize the current through multiple paralleled power modules during switching transitions. This allows the use of almost any kind of power semiconductors and extends the temperature range from cryogenic temperatures up to more than 150°C. Due to the better symmetration, the losses can be distributed more equally which allows tighter junction temperature distribution and connection of more semiconductors in parallel. This enables the use of smaller and/or more powerful modules. Due to the active control of switch on and off times, the method allows to balance the current during switch on and off which equals the switching losses across all dies/modules.

Preferred embodiments of the invention provide a method to actively symmetrize the load current during switching in power systems that make use of multiple paralleled power semiconductors or power modules. During power semiconductors turn on or off the current in the semiconductor in- or decreases ($di/dt$) in a fast manner. This leads to an induced voltage across the stray inductances within the power circuit: $u(t) = L * di/dt$. The higher the value of $di/dt$, the higher the voltage across the stray inductance. If for instance two power modules are put in parallel, and the current $i = i_1 + i_2$ and $i_1 = i_2$ is distributed equally among them, both show the same voltage drop ($u(t)$) during the switching transitions. If there is some kind of asymmetry so that $i_1$ is not the same as $i_2$ ($i_1 \neq i_2$), the voltage drop also differs. This is the case when one module switches earlier or faster than another, for example. The difference in voltage drop is detected by a dedicated circuit. A control circuit or device is used to change the pulse pattern so that the slower module is turned on a little bit earlier. This can be repeated until both voltage drops are equal again. Variation steps in the range of roughly 10 ns have proved useful. The switching behaviour can be adjusted by FPGAs or microcontrollers.

Embodiments of the invention are explained below referring to the accompanying drawings in which:

Fig. 1 a schematic view of an aircraft with an electronic device and a power circuit for supplying the electronic device with electrical power;

Fig. 2 a block diagram of an embodiment of the power circuit including two power modules coupled in parallel;

Fig. 3 a circuit diagram of a half-bridge circuit that may be included in the power modules of Fig. 2;

Fig. 4 a circuit diagram of the half-bridge circuits of the two power modules of Fig. 2 coupled in parallel.

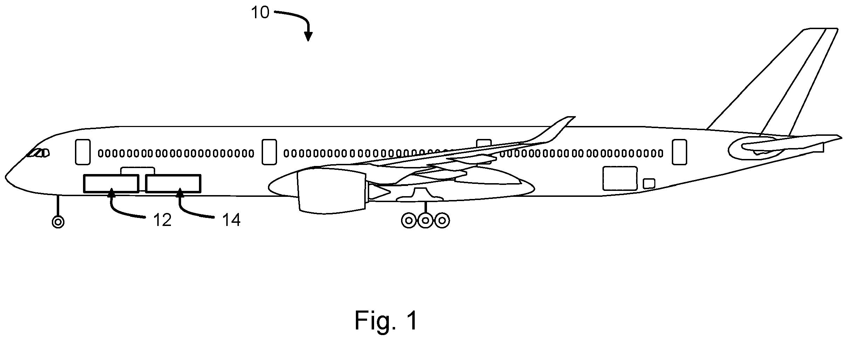

Fig. 1 shows an aircraft 10 with an electric or electronic device 12 and an electrical power circuit 14 for supplying the electric or electronic device 12 with electrical power. The electric or electronic device 12 can be any electric or electronic device to be used on the aircraft 10, such as a part of a flight computer, a flight controller, an electronic instrument, a computing device, a personal computer, a communication device, a transmitter, a receiver, or a part of a passenger entertainment system, an electric motor, an electric propulsion component or a high-power consumer, especially including an electric motor for propulsion.

The electrical power circuit 14 is used to supply adequate electrical power to the electric or electronic device 12. The electrical power circuit 14 may be provided in the form of a single module or a sub-unit with several separate modules. The power module 14 transfers power from a DC or AC source (often mains power, e.g., AC adapter) to a DC load 24, such as a computing device or an electronic device, or an AC load, such as an electric motor, while converting voltage and current characteristics. In some embodiments, the power circuit 14 can be (part of) a motor inverter.

The power circuit 14 has power semiconductors for high current throughput. In some embodiments, the power circuit 14 comprises a switched-mode power supply (SMPS). A switched-mode power supply is an electronic power supply that incorporates a switching regulator to convert electrical power efficiently.

In some embodiments, the power circuit 14 has a half-bridge configuration. In some embodiments, the power circuit 14 comprises two or more half-bridge configurations that are electrically coupled in parallel.

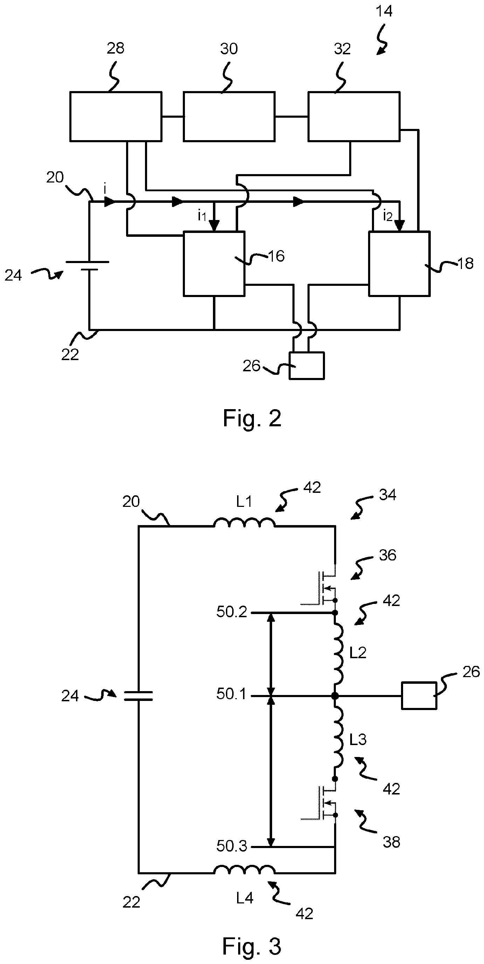

Fig. 2 shows a block diagram of an embodiment of the power circuit 14 which comprises a first electrical power module 16 and a second electrical power module 18 that are coupled in parallel between a high voltage bus 20 and a low voltage bus 22 of a power supply 24. The first and second power modules 16, 18 supply electrical power to a load 26. Each of the modules 16, 18 may comprise a half-bridge configuration, for example.

A current i from the power supply 24 is distributed between the first and second power modules 16, 18 such that a current $i_1$ flows through the first module 16 and a current $i_2$ flows through the second module 18 and i = $i_1 + i_2$. In an ideal case, $i_1 = i_2$. If $i_1$ differs from $i_2$, i.e. $i_1 \neq i_2$, switching losses increase. In a power circuit 14 with n modules electrically coupled in parallel between the high and low voltage lines 20, 22, the current i should, in an ideal case, be shared equally so that a current of i/n flows through each module. The power circuit 14 further comprises a voltage measurement device 28, a computing device 30 and a control device 32.

Each of the power modules 16, 18 comprises a half-bridge configuration 34. Fig. 3 illustrates a circuit diagram of a half-bridge configuration 34 that may be included in the power modules 16, 18. The half-bridge configuration 34 comprises a high side switch 36 and a low side switch 38 that are electrically coupled in series at an output node 40 that is electrically coupled to the load 26. Each of the high side switch 36 and low side switch 38 may be provided by a power transistor device such as a MOSFET or IGBT, which may be silicon-based, or a SiC-based or GaN-based transistor device. The transistor device comprises a source terminal S, a drain terminal D and a gate terminal G. The source S of the low side switch 38 is electrically coupled to the low voltage supply bus 22, the drain D of the low side switch 38 is electrically coupled to the source S of the high side switch 36 at the output node 40 and the drain D of the high side switch 38 is electrically connected to the high voltage bus 20. The gate terminals G of the high and low side switches 36, 38 are electrically coupled to the control device 32 so that the control device 32 can control the gate and, therefore, switching of the high side switch 36 and the low side switch 38.

The voltage measurement device 28 is configured to measure voltage $u_1$ and $u_2$ of a parasitic element 42 of the first and second electrical power modules 16, 18, respectively. Examples of some but not all parasitic elements 42 of the power circuit 14 at which measurements could be made are shown in Fig. 3. In electrical networks, a parasitic element is a circuit element (resistance, inductance or capacitance) that is possessed by an electrical component but which it is not desirable for it to have for its intended purpose. For instance, a resistor is designed to possess resistance, but will also possess unwanted parasitic inductance.

Parasitic elements are unavoidable. All conductors possess resistance and inductance. Component designers will strive to minimise parasitic elements but are unable to eliminate them. Discrete components will often have some parasitic values detailed on their datasheets to aid circuit designers in compensating for unwanted effects. These parasitic elements 42 may be located within the power modules 16, 18 and/or in the connections between the power modules 16, 18 and the further components of the power circuit 14, for example the electrical connections between the power modules 16, 18 and the power supply 24.

In the following, a new method for high speed and accurate voltage measuring without influencing the power module 14 itself is described. The internal parasitic elements 42 are used for voltage measurement using standard measurement techniques.

Fig. 3 shows the half-bridge configuration 34 with some of the typical parasitic elements 42, e.g. parasitic inductances L1-L4, of the half-bridge configuration at which the voltage could be measured. L2 represents a source inductance at which the voltage could be measured.

Due to the electrical behaviour of inductors, each change in current (di/dt) results in an induced voltage:

$$(1) \qquad u(t) = L * di/dt.$$

In most state-of-the-art power modules, a first to third connection point 50.1-50.3 as shown in Fig. 3 are easily accessible wherein the first connection point 50.1 is the load connection, and the second and third connection points 50.2, 50.3 are Kelvin-source connections of the power module 16, 18 or of the die carrying it (a die, in the context of integrated circuits, is a small block of semiconducting material on which a given functional circuit is fabricated).

The values for L2 and L3 have to be predetermined once at the beginning. As same modules do not vary a lot for these parameters, calibration does not have to be done for all devices of the same unit.

The voltage measurement as described provides at least one, several or all of the following advantages:

- no additional parts in the power circuit are necessary
- little or no influence on the power circuit since the voltage drop across a stray inductance is measured
- very fast and accurate measurement
- measurement of the real transistor current not the load current

The voltage measurement device 28 of the power circuit 14 is configured to measure the voltage of a parasitic element 42 of the power circuit 14, for example the voltage $u_1$ of the inductance L2 of the first power module 16 and the voltage $u_2$ the inductance L2 of the second electrical power module18. The control device 32 is configured to supply a signal to the power circuit 14 in response to the determination of the voltage drop across the parasitic element.

The voltage measuring method may be used in the power circuit 14 shown in Fig. 2 to equalize the current distribution or sharing between the two or more modules or circuits connected in parallel., e.g. the modules 16, 18. During switching of power semiconductor transistors 36, 38, i.e. during turn on or turn off, the current in the semiconductor in- or decreases (di/dt) in a fast manner. This leads to an induced voltage across the stray inductances, e.g. L2 within the power circuit 14 and/or modules 16, 18: u(t) = L * di/dt. The higher the di/dt, the higher the voltage across the stray inductance.

The voltage measurement device 28 of the power circuit 14 is configured to measure the voltage $u_1$ of the inductance L2 of the first power module 16 and the voltage $u_2$ the inductance L2 of the second electrical power module18.

For two power modules 16, 18 that are coupled in parallel and for a current i that is equally distributed between them, i = i1 + i2 and i1 = i2, both show the same voltage drop (u(t)) during the switching transitions. If there is some kind of asymmetry so that i1 is not the same as i2 (i1 ≠ i2), the voltage drop also differs, which is detected by the dedicated circuit. This is the case when one module switches earlier or faster than another, for example.

The computing device 30 of the power circuit 14 is configured to determine a difference between $u_1$ and $u_2$. In response to the determination that there is a difference between $u_1$ and $u_2$ and therefore, that the current i is unequally shared so that $i_1$ and $i_2$ are not equal, the control device 32 supplies a signal to one or both of the first and second power electrical modules 16, 18 so as to symmetrize current flow through the first and second electrical power module 16, 18. For example, the control circuit or device 32 can be used to change the pulse pattern so that the slower module is turned on a little bit earlier. This method can be repeated and the pulse pattern is appropriately adjusted until both voltage drops u1 and u2 are equal. Variation steps in the range of roughly 10 ns have proved useful.

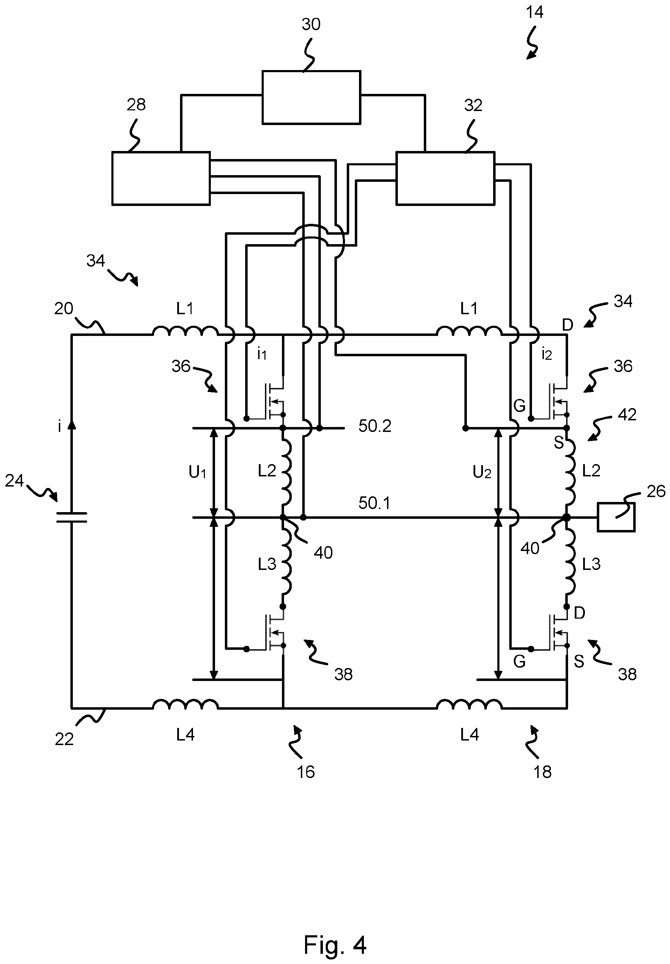

Referring to Fig. 4, in an example of the method, for the first power module 16, a voltage $u_1$ between the second connection point 50.2 and first connection point 50.1 is measured over the second parasitic inductance L2 by the voltage measurement device 28 for determining the current through the high-side transistor 36. For the second power module 18, a voltage $u_2$ between the second connection point 50.2 and first connection point 50.1 is measured over the second parasitic inductance L2 by the voltage measurement device 28 for determining the current through the high-side transistor 36.

The computing device 30 determines whether $u_1$ and $u_2$ are the same. Preferably, the computing device 30 determines whether the difference between $u_1$ and $u_2$ is greater than a predetermined value. This predetermined value can be selected such that the switching losses arising from the unequal distribution of current though the first and second modules 16, 18 are undesirably high. If $u_1$ and $u_2$ differ, the control device 32 actively controls and adjusts the switching of the half-bridge circuit 34 in one or both of the modules 16, 18. For example, the half bridge circuit 34 of the second module 18 may be switched on earlier, by a predetermined period, than the half-bridge circuit 34 of the first module 16. The method may be repeated and the predetermined period increased until u1 and u2 are equal or the difference between u1 and u2 is considered sufficiently small.

A power circuit 14 and a method is provided in which the current through multiple paralleled power paths, e.g. modules 16, 18 or half-bridges 34, is actively symmetrized during switching transitions. This allows the use of almost any kind of power semiconductors and extends the temperature range from cryogenic temperatures up to more than 150°C. Due to the better symmetrisation, the losses can be distributed more equally which allows tighter junction temperature distribution and connection of more semiconductors in parallel. Active control of switch on and off times, allows the current during switch on and switch off and the switching losses across all dies/modules to be equalized.

**Reference sign list:**

| | |
|---|---|
| 10 | aircraft |
| 12 | electronic device |
| 14 | power circuit |
| 16 | first module |
| 18 | second module |
| 20 | high voltage bus |
| 22 | low voltage bus |
| 26 | load |
| 24 | power supply |
| 28 | voltage measurement device |
| 30 | computing device |
| 32 | control device |
| 34 | half-bridge configuration |
| 36 | high side switch |
| 38 | low side switch |
| 40 | output node |
| 42 | stray inductance |

| | |
|---|---|
| 50.1 | first connection point |
| 50.2 | second connection point |
| 50.3 | third connection point |
| L1 | first parasitic inductance (example for parasitic element, stray inductance) |
| L2 | second parasitic inductance (example for parasitic element, stray inductance) |
| L3 | third parasitic inductance (example for parasitic element, stray inductance) |
| L4 | fourth parasitic inductance (example for parasitic element, stray inductance) |

| | |
|---|---|
| $u_1$ | voltage measured at first parasitic element |
| $u_2$ | voltage measured at second parasitic element |

**Claims**

1. Voltage measuring method for measuring voltage in an electrical power circuit (14) comprising at least one switching element (36, 38), the voltage measuring method comprising: measuring the voltage over a parasitic element (42, L1-L4) of the power circuit (14).

2. Voltage measuring method according to claim 1, wherein the parasitic element (42) is a stray inductance (L1-L4).

3. Voltage measuring method according to claim 1 or claim 2, wherein a time-dependent voltage is measured during a switching operation of the at least one switching element (36, 38).

4. Voltage measuring method according to any of the preceding claims, wherein the electrical power circuit (14) comprises a plurality of electrical power modules (16, 18) coupled in parallel between a high voltage supply terminal (20) and a low voltage supply terminal (22), each electrical power module (16, 18) comprising at least one switching element (36, 38), wherein the voltage measuring method comprises:

   measuring the voltage $u_1$ over a parasitic element (42) of a first one (16) of the plurality of electrical power modules (16, 18) and measuring the voltage $u_2$ over a parasitic element (42) of a second one (18) of the plurality of electrical power modules (16, 18), and
   if $u_1$ and $u_2$ are unequal, adjusting the switching of one or both of the first and second electrical power modules (16, 18), or
   during switching of the first and second modules (16, 18), measuring the time dependent voltage $u_1(t)$ over a parasitic element (42) of a first one (16) of the first and second electrical power modules (16, 18) and measuring the time dependent voltage $u_2(t)$ over a parasitic element (42) of a second one (18) of the first and second electrical power modules (16, 18), and
   if $u_1(t)$ and $u_2(t)$ are unequal, adjusting the switching of one or both of the first and second electrical power modules.

5. Voltage measuring method according to claim 4, wherein

   if the difference between $u_1$ and $u_2$ is greater than a predetermined value, the switching of one or both of the first and second electrical power modules (16, 18) is adjusted, or

if the difference between $u_1(t)$ and $u_2(t)$ is greater than a predetermined value, the switching of one or both of the first and second electrical power modules (16, 18) is adjusted.

6. Voltage measuring method according to claim 4 or claim 5, wherein the adjusting the switching comprises:
   actively controlling the switch-on time and/or the switch-off time of one or both of the first and second electrical power modules (16, 18) and/or actively controlling the slope of the switch-on of one or both of the first and second electrical power modules (16, 18) to symmetrize current flow through the first and second electrical power modules (16, 18).

7. Voltage measuring method according to any of claims 4 to 6, wherein the adjusting the switching comprises controlling the switch-on and/or the switch-off of one or both of the first and second electrical power modules (16, 18) such that the switch-on of the first and second electrical power modules (16, 18) is non-simultaneous and/or such that the switch-off of the first and second electrical power modules (16, 18) is non-simultaneous.

8. Voltage measuring method according to any of claims 4 to 7, wherein the adjusting the switching comprises shifting the switch-on of one of the first and second electrical power modules (16, 18) compared to the other one of the first and second electrical power modules (18, 16) by a predetermined period.

9. Voltage measuring method according to any of claims 4 to 8, wherein each electrical power module (16, 18) comprises a half-bridge circuit (34) comprising a high side switch (36) and a low side switch (38) coupled in series at an output node (40), and if $u_1$ and $u_2$ are unequal, or $u_1(t)$ and $u_2(t)$ are unequal, a timing of the switching of the half-bridge circuit (34) of one or both of the first and second electrical power modules (16, 18) is adjusted such that the half-bridge circuits (34) switch non-simultaneously.

10. Voltage measuring method according to claim 9, wherein the high side switch (36) and the low side switch (38) each comprise a transistor device comprising a gate and the timing of the switching of the half-bridge circuit (34) comprises adjusting the gate control signal supplied to the gate of one or both of the high side switch (36) and the low side switch (38) of that half-bridge circuit (34).

11. Voltage measuring method according to claim 10, wherein adjusting the gate control signal supplied to the gate comprises adjusting a pulse pattern of a gate control signal supplied to the gate of one or both of the high side switch (36) and the low side switch (38).

12. Power circuit (14) configured to perform the voltage measuring method according to any of the preceding claims.

13. Power circuit (14) according to claim 12, comprising

    a voltage measurement device (28) configured to measure voltage $u_1$ of a parasitic element (42) of a first electrical power module (16) and a voltage $u_2$ of a parasitic element (42) of a second electrical power module (18);
    a computing device (30) configured to determine a difference between $u_1$ and $u_2$, and
    a control device (32) configured to supply a signal to one or both of the first and second power electrical modules (16, 18) so as to symmetrize current flow through the first and second electrical power module (16, 18).

14. Power circuit (14) according to any of claims 12 or 13, wherein the first and second power modules (16, 18) each comprise a half-bridge circuit (34) comprising a high side switch (36) and a low side switch (38) coupled in series at an output node (40), and the control device (32) comprises a microcontroller or a Field Programmable Gate Array.

15. Aircraft (10) comprising a power circuit (14) according to any of claims 12 to 14.

Fig. 1

Fig. 2

Fig. 3

Fig. 4

Europäisches
Patentamt

European
Patent Office

Office européen
des brevets

# EUROPEAN SEARCH REPORT

**Application Number**

EP 23 20 6018

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/162902 A1 (LIZAMA IGNACIO [DE] ET AL) 11 June 2015 (2015-06-11) | 1-4,6-15 | INV. G01R19/00 |
| A | * paragraphs [0029] - [0096]; claims 1-18; figures 1-13f * | 5 | G01R31/42 H02M1/00 H02M3/335 H03K17/14 |
| X | US 11 444 613 B1 (LI ZHEMING [DE] ET AL) 13 September 2022 (2022-09-13) | 1-3,12, 14,15 | |
| A | * columns 5-26; claims 1-16; figures 1-8 * | 4-11,13 | |
| X | WO 2015/070344 A1 (TM4 INC [CA]) 21 May 2015 (2015-05-21) | 1-3,12, 14,15 | |
| A | * paragraphs [0004] - [0071]; claims 1-25; figures 1-7 * | 4-11,13 | |
| X | CN 108 880 515 A (GUANGZHOU AUTOMOBILE GROUP CO) 23 November 2018 (2018-11-23) | 1-3,12, 15 | |
| A | * paragraphs [0036] - [0099]; claims 1-10; figures 1-6 * | 4-11,13, 14 | |
| A | DE 10 2020 203123 A1 (CONTINENTAL TEVES AG & CO OHG [DE]) 5 August 2021 (2021-08-05) * the whole document * | 1-15 | |

**TECHNICAL FIELDS SEARCHED (IPC)**

G01R
H03K
H02M

The present search report has been drawn up for all claims

| Place of search | Date of completion of the search | Examiner |
|---|---|---|
| Munich | 20 April 2024 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................
& : member of the same patent family, corresponding document

EPO FORM 1503 03.82 (P04C01)

# EP 4 545 980 A1

## ANNEX TO THE EUROPEAN SEARCH REPORT
## ON EUROPEAN PATENT APPLICATION NO.

EP 23 20 6018

This annex lists the patent family members relating to the patent documents cited in the above-mentioned European search report.
The members are as contained in the European Patent Office EDP file on
The European Patent Office is in no way liable for these particulars which are merely given for the purpose of information.

20-04-2024

| Patent document cited in search report | | | Publication date | Patent family member(s) | | | Publication date |
|---|---|---|---|---|---|---|---|
| US 2015162902 | A1 | | 11-06-2015 | CN | 104716833 | A | 17-06-2015 |
| | | | | EP | 2884661 | A1 | 17-06-2015 |
| | | | | US | 2015162902 | A1 | 11-06-2015 |
| US 11444613 | B1 | | 13-09-2022 | NONE | | | |
| WO 2015070344 | A1 | | 21-05-2015 | CA | 2930188 | A1 | 21-05-2015 |
| | | | | CN | 105814780 | A | 27-07-2016 |
| | | | | KR | 20160086344 | A | 19-07-2016 |
| | | | | US | 2016301308 | A1 | 13-10-2016 |
| | | | | WO | 2015070344 | A1 | 21-05-2015 |
| CN 108880515 | A | | 23-11-2018 | NONE | | | |
| DE 102020203123 | A1 | | 05-08-2021 | NONE | | | |

EPO FORM P0459

For more details about this annex : see Official Journal of the European Patent Office, No. 12/82

REFERENCES CITED IN THE DESCRIPTION

**Patent documents cited in the description**

- US 4234805 A